# EUROPÄISCHE PATENTSCHRIFT

(11) **EP 1 173 375 B1**
(45) Veröffentlichungstag und Bekanntmachung des Hinweises auf die Patenterteilung: **31.03.2004**
(21) Anmeldenummer: 00936622.0
(22) Anmeldetag: 13.04.2000
(51) Int. Cl.: B65G 54/00, B06B 3/00, G10K 15/00, H01L 21/68

(54) **VERFAHREN ZUM BERÜHRUNGSLOSEN GREIFEN UND POSITIONIEREN VON BAUTEILEN**
METHOD FOR CONTACTLESSLY GRIPPING AND POSITIONING COMPONENTS
PROCEDE POUR PRENDRE, TENIR ET POSITIONNER DES COMPOSANTS SANS CONTACT

(30) Priorität: 14.04.1999 DE 19916859
(43) Veröffentlichungstag der Anmeldung: 23.01.2002
(73) Patentinhaber: Technische Universität München Institut für Werkzeugmaschinen und Betriebswissenschaften, 80290 München (DE)
(72) Erfinder: HÖPPNER, Jürgen, D-85777 Fahrenzhausen (DE); ZIMMERMANN, Josef, D-93047 Regensburg (DE)
(74) Vertreter: Tönhardt, Marion, Dr.
(86) Internationale Anmeldenummer: PCT/DE2000/001152
(87) Internationale Veröffentlichungsnummer: WO 2000/061474

(56) Entgegenhaltungen:
- DE-C- 19 916 872
- US-A- 4 284 403
- US-A- 5 036 944
- PATENT ABSTRACTS OF JAPAN vol. 018, no. 638 (P-1837), 5. Dezember 1994 (1994-12-05) & JP 06 249640 A (HITACHI TECHNO ENG CO LTD), 9. September 1994 (1994-09-09)

## Beschreibung

Die vorliegende Erfindung betrifft ein Verfahren zum berührungslosen Greifen, Halten und Positionieren von vorzugsweise berührungsempfindlichen Bauteilen.

Bei berührungsempfindlichen Bauteilen, wie z. B. Wafern, werden bei einer mechanischen Berührung an den Berührungsstellen Partikel abgelöst, die je nach vorgegebenen Randbedingungen einen technologischen Arbeitsprozeß störend beeinflussen können.

Zur Vermeidung einer Partikelgeneration oder einer Beschädigung der Oberfläche eines Bauelements wurden berührungslos wirkende Greifvorrichtungen entwickelt, die zum Festhalten des Bauelements den Über- oder/und Unterdruck strömender Gase nutzen, wie in der US 5080549 beschrieben. Nachfolgend wird diese Greifertype als Pneumatik-Greifer bezeichnet.

Es ist jedoch beim Transport von Wafern in Reinräumen von Bedeutung, daß die in den Reinräumen technologisch vorgeschriebene Luftströmung (Laminar-flow-Zustand) nicht beeinflußt wird. Die aus den Düsen der Greifer aus- oder einströmende Luft stört den Laminar-flow-Zustand im Reinraum und erhöht somit die Gefahr, daß vagabundierende Partikel die Fertigungsqualität beeinflussen.

Ein weiterer Nachteil von blasenden Greifern ist die starke Verwirbelung der aus den Düsen austretenden Luft. So können z. B. Partikel, die an der Unterseite der Wafer anhaften, unkontrolliert vagabundieren und sich auch auf der Waferoberseite absetzen.
Weiterhin ist aus der EP 064 539 A1 bekannt, flächige Stücke, vorzugsweise Papier, mittels einer Schalldruck erzeugenden Anordnung von Schallgeneratoren berührungslos zu transportieren. Um ein Abgleiten des Papiers von der Transportbahn zu verhindern, sind seitliche mechanische Anschläge vorgesehen. Da sich jedoch bei einer mechanischen Berührung Partikel vom Transportgut oder vom Anschlag ablösen können, ist diese Anordnung für das Handling von Wafern nicht geeignet.

Es ist die Aufgabe der Erfindung, eine Technologie bereitzustellen, die die Nachteile des vorstehend aufgeführten Standes der Technik vermeidet.

Die Aufgabe wird mit einem Verfahren nach Anspruch 1 gelöst.

Nach Anspruch 1 wird ein Verfahren zum berührungslosen Greifen und Halten von Bauteilen bereitgestellt, wobei die Greif- und Haltekräfte nach dem Prinzip der akustischen Stehwellenlevitation erzeugt werden. Die Besonderheit dieses Verfahrens besteht darin, daß lediglich die Randabschnitte der Bauteile in das akustische Kraftfeld hineinragen und durch Bemoulti-Kräfte fixiert werden. Somit kann die Summe der schall abstrahlenden Flächen der Schallerzeugungsmittel wesentlich kleiner sein als die Oberfläche des Bauteils.

Im Gegensatz dazu sind bei der herkömmlichen akustischen Stehwellenlevitation die schallabstrahlenden Flächen wesentlich größer als die Oberfläche des levitierten Objektes.

Bei dem Verfahren nach Anspruch 1 wird davon ausgegangen, daß die in das akustische Kraftfeld hineinragenden Randabschnitte der Bauteile so ausgebildet sind, daß sie als Reflektor wirken, d. h., der bei der herkömmlichen akustischen Stehwellenlevitation immer notwendige Reflektor ist bei dem Erfindungsgegenstand nach Anspruch 1 nicht erforderlich.

Es ist besonders zu erwähnen, daß keinesfalls nur durchgehend flache Objekte, wie z. B. Wafer, gehalten werden können. Lediglich die Randflächen bzw. einige Abschnitte dieser Randflächen müssen die erforderlichen Reflexionseigenschaften aufweisen, d. h., sie müssen die auftreffenden Schallwellen wieder in Richtung der Schallquelle reflektieren. Es ist ferner zu erwähnen, daß die als Reflektor wirkenden Randflächen auch innerhalb der Bauteilfläche liegen können, wenn das Bauteil z. B. Bohrungen oder andere Durchbrüche aufweist.

Nach Anspruch 2 wird das Verfahren nach Anspruch 1 durch separate Reflektoren ergänzt, die die Haltekräfte erhöhen. Diese Weiterbildung des Verfahrens wird dann vorgesehen, wenn die Randabschnitte des Objektes weniger gute Reflexionseigenschaften aufweisen.

Nach Anspruch 3 wird das Verfahren nach Anspruch 1 durch die Bereitstellung von Schallquellen an Stelle der Reflektoren weitergebildet, wodurch die Haltekraft des Greifers weiter erhöht werden kann. Dem Fachmann ist klar, daß die jeweils gegeneinander strahlenden Schallquellen aufeinander abgestimmt werden müssen, um die Energieknoten auf eine Ebene zu justieren.

Zusammenfassend ist zu erwähnen, daß das erfindungsgemäße Verfahren besonders vorteilhaft in technologischen Prozessen eingesetzt werden kann, in denen auch die Arbeitsschritte waagerechtes und senkrechtes Transportieren sowie auch das Lagern bzw. Zwischenlagern nach dem Prinzip der akustischen Levitation oder nach dem Prinzip des Schalldrucks im Nahbereich der Schallquelle erfolgt. Ein solches System arbeitet auch bei fehlender Gravitation sehr zuverlässig.

Die Erfindung wird nachfolgend anhand eines Ausführungsbeispiels in Verbindung mit schematischen Zeichnungen näher erläutert:
- Fig. 1a: zeigt die Erfindung beim Halten einer Kreisplatte in der Seitenansicht.
- Fig. 1b: zeigt die Erfindung beim Halten einer Kreisplatte in der Draufsicht.
- Fig. 2: zeigt die Erfindung beim Halten eines Kreisringes in der Seitenan-sicht.
- Fig. 3: zeigt die Erfindung beim Halten eines Kreisringes in der Draufsicht.

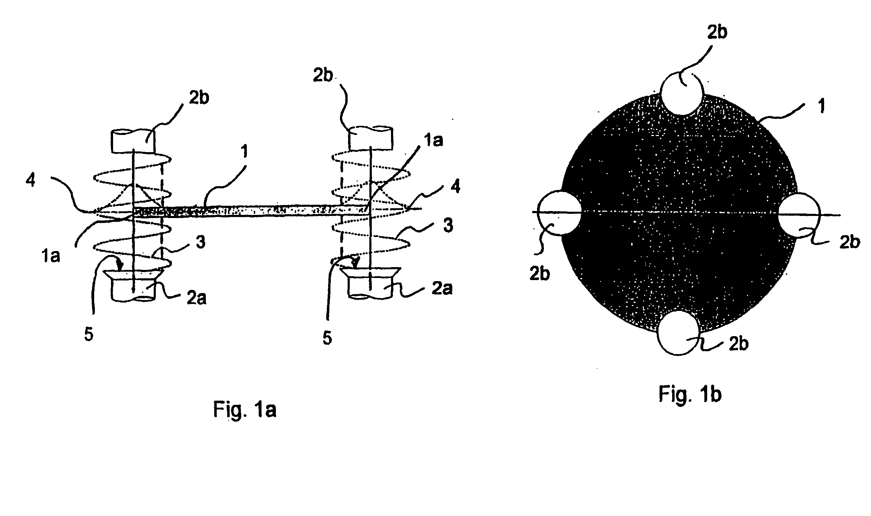

Die Fig. 1a, b zeigen eine Vorrichtung zum Halten eines kreisförmigen Bauteils 1. Vier Schallquellen 2a sind jeweils um 90 Grad versetzt am Randabschnitt 1a des Bauteils 1 angeordnet. Gegenüber diesen Schallquellen 2a sind jeweils vier Reflektoren 2b angeordnet. Von den Schallquellen 2a wird Ultraschall abgestrahlt, der sich als Schallwelle 3 in Richtung der Reflektoren 2b ausbreitet und dort reflektiert wird, so daß sich eine stehende Welle mit mehreren Energieknoten ausbildet. Im vorliegenden Beispiel wird das Bauteil im Energieknoten 4 gehalten.

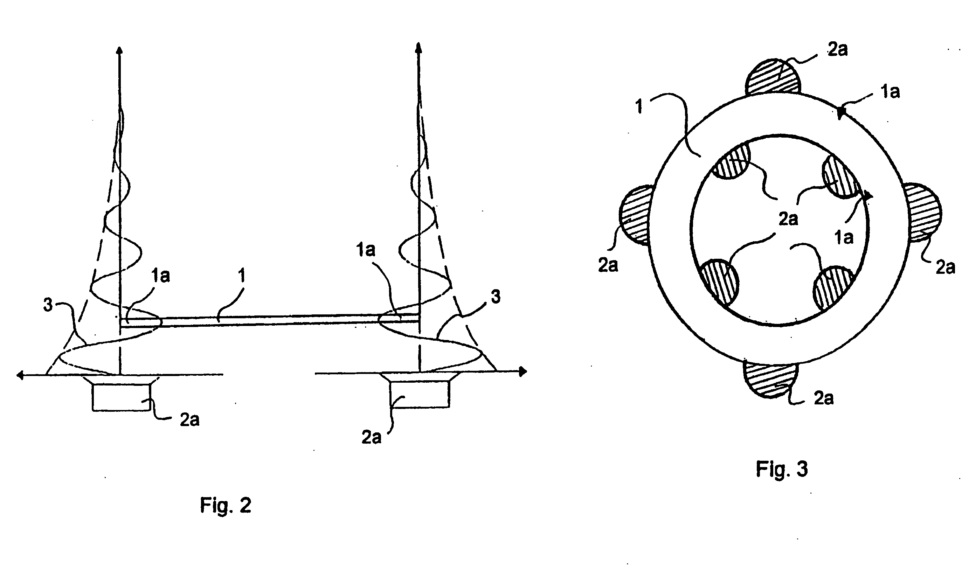

Die Fig. 2 zeigt eine zweite Ausführungsform in der Seitenansicht. Bei dieser Ausführungsform sind lediglich Schallquellen 2a im Randbereich 1 des Bauteils 1 angeordnet. Da die Reflektoren fehlen, nimmt die Schallintensität in der Schallausbreitungsrichtung stark ab, so daß die Haltekraft geringer ist als bei einer Anordnung mit Reflektoren. Durch eine Erhöhung der Schalleistung kann die Verminderung der Haltekraft jedoch kompensiert werden. Der Vorteil dieser Anordnung besteht darin, daß mit diesem Greifer Bauteile auch an Arbeitsstationen positioniert werden können, bei denen die räumliche Gegenüberlage von Reflektoren stören würde.

Die Fig. 3 zeigt einen Aufbau nach der zweiten Ausführungsform, jedoch für ein ringförmiges Bauelement. Die Draufsicht zeigt, daß die Schallquellen 2a so angeordnet sind, daß der äußere Randabschnitt und der innere Randabschnitt des Bauteils von den Schallwellen umfaßt wird.

Diese Beispiele zeigen, daß die Anordnung der Schallquellen und der Reflektoren von der geometrischen Form des Bauteils abhängig ist. Der Fachmann kann daher bei Kenntnis der vermittelten technischen Lehre selbst geeignete Anordnungen auswählen, ohne dabei erfinderisch tätig werden zu müssen.

## Patentansprüche

1. Verfahren zum berührungslosen Greifen und Halten von Bauteilen **(1)** mit flächigen Randabschnitten **(1a)**, wobei das Verfahren mit folgenden Schritten ausgeführt wird:
- Erzeugen von Levitationsschallwellen **(3)** mittels Schallerzeugungsmittel **(2a)**,
- Halten des Bauteils **(1)** an seinem flächigen Randabschnitt in einem ausgewählten Energieknotenpunkt **(4)** der Schallwellen **(3)** in einer Halteebene **(5)** wobei sich die flächigen Randabschnitte **(1a)** nur teilweise in den Wirkbereich der schallabstrahlenden Flächen **(6)** der Schallerzeugungsmittel **(2a)** erstrecken und die Summe **(A)** der schallabstrahlenden Flächen **(6)** der Schallerzeugungsmittel **(2a)** kleiner als die Oberfläche **(B)** des Bauteils **(1)** ist.

2. Verfahren nach Anspruch 1, wobei den Schallerzeugungsmitteln **(2a)** Reflektoren **(2b)** zugeordnet sind.

3. Verfahren nach Anspruch 1, wobei den Schallerzeugungsmitteln weitere Schallquellen zugeordnet sind.

## Claims

1. A method for the contact-less gripping and holding of components (1) having flat edge portions (1a), wherein the method is performed with the following steps:
- the generation of levitation sound waves (3) by means of sound generating means (2a),
- holding the component (1) at its flat edge portion in a selected energy nodal point (4) of the sound waves (3) in a holding plane (5), the flat edge portions (1a) extending only partially into the zone of action of the sound-radiating surfaces (6) of the sound generating means (2a) and the sum (A) of the sound-radiating surfaces (6) of the sound generating means (2a) being less than the surface area (B) of the component (1).

2. A method according to claim 1, wherein reflectors (2b) are associated with the sound generating means (2a).

3. A method according to claim 1, wherein other sound sources are associated with the sound generating means.

## Revendications

1. Procédé pour prendre et maintenir sans contact des éléments de construction (1) ayant des bords plats (1a), ledit procédé étant effectué selon les étapes suivantes :
- production d'ondes sonores de lévitation (3) au moyen d'un dispositif de production de son (2a),
- maintien de l'élément de construction (1) par ses bords plats à un noeud d'énergie donné (4) des ondes sonores (3) à un niveau de maintien (5), les rebords plats (1a) ne s'étendant que partiellement dans le champ d'action des surfaces (6) émettant des ondes sonores du dispositf de production de son (2a), et la somme (A) des surfaces (6) émettant des ondes sonores du dispositif de production de son (2a) étant inférieure à la surface (B) de l'élément de construction (1).

2. Procédé selon la revendication 1, dans lequel le dispositif de production de son (2a) est muni de réflecteurs (2b).

3. Procédé selon la revendication 1, dans lequel le dispositif de production de son (2a) est muni de sources sonores.
